# EUROPEAN PATENT SPECIFICATION

(11) **EP 1 032 485 B1**
(45) Date of publication and mention of the grant of the patent: **27.08.2003**
(21) Application number: 98954779.9
(22) Date of filing: 20.11.1998
(51) Int. Cl.: B24B 37/04, B24B 55/02, B24B 49/14

(54) **WAFER POLISHING MACHINE**
HALBLEITERSCHEIBEN-LÄPPMASCHINE
POLISSEUSE POUR TRANCHES DE SILICIUM

(30) Priority: 21.11.1997 JP 33803397
(43) Date of publication of application: 06.09.2000
(73) Proprietor: Ebara Corporation, Tokyo 144-8510 (JP)
(72) Inventor: KIMURA, Norio, Fujisawa-shi, Kanagawa 251-0021 (JP); ISHII, Yu, Yokohama-shi, Kanagawa 235-0022 (JP)
(74) Representative: Wagner, Karl H., Dipl.-Ing.
(86) International application number: PCT/JP98/05244
(87) International publication number: WO 99/026760

(56) References cited:
- EP-A- 0 803 329
- US-A- 4 471 579
- US-A- 5 036 625

## Description

### TECHNICAL FIELD

The present invention relates to a polisher, in particular, a polisher for polishing a semiconductor wafer, and more specifically to a system for cooling a turn table of such a polisher having a polishing surface for polishing a semiconductor wafer.

### BACKGROUND ART

In the production of semiconductor devices, it is necessary to polish semiconductor wafers by means of a polisher to thereby flatten a surface thereof onto which semiconductor circuits are provided.

A typical polisher of this type is for example described in EP-A-0 803 329. The polisher includes a turn table provided with a polishing pad on an upper surface thereof, a drive shaft fixedly connected to the center of a lower surface of the turn table for drivingly rotating the turn table about its axis, a wafer carrier for holding a semiconductor wafer in contact with an upper polishing surface of the polishing pad to polish the wafer, and a slurry nozzle for supplying slurry onto the polishing surface to effect a polishing operation mechanically and chemically by a combination of the polishing pad and the supplied slurry. It is therefore desirable for a turn table of such a type of polisher to be positively cooled in order to deprive the polishing pad of heat generated in a polishing operation, although the polishing pad is cooled by the slurry to some extent. Consequently, it is conventional for such a polisher to be provided with a cooling system including a cooling fluid path extending inside of the turn table for flowing therethrough a cooling fluid received from an outside cooling fluid supply. However, since a fluid coupler provided in the cooling system to receive a cooling fluid from an outside cooling supply is conventionally located in a drive shaft which is connected to a drive mechanism for driving the shaft, the construction of a combination of the drive shaft and those devices associated with the shaft is complicated thereby causing problems of cost, maintenance and so on.

An object of the present invention is therefore to solve such problems as are involved in such a conventional polisher.

### DISCLOSURE OF INVENTION

In accordance with the present invention, a polisher comprises a turn table having first and second end surfaces which are substantially normal to an axis of the turn table. The first end surface defines a polishing surface for polishing an article. A drive shaft is connected to the turn table in such a manner that the shaft extends along the axis of the turn table outwardly from the second end surface of the turn table. The polisher further includes a cooling system which comprises a cooling fluid path provided in the turn table for passing a cooling fluid therethrough to deprive the polishing surface of heat generated in a polishing operation and a fluid coupler provided at the center of the first end surface of the turn table for fluidly connecting the cooling fluid path with a cooling fluid supply outside of the turn table.

In a preferred embodiment, the turn table comprises a rotatable disc and a disc-like polishing member such as a synthetic resin polishing pad, a grindstone disc or the like axially aligned with the rotatable disc. The rotatable disc defines the above-noted second end surface of the turn table and the polishing member defines the polishing surface. The cooling system includes a cooling disc provided between the polishing member and the rotatable disc in which the above-stated cooling fluid path is formed. The cooling disc is removably connected to the rotatable disc. Alternatively, the cooling disc may be integrally formed with or integrally incorporated into the rotatable disc. The polishing member is provided with an opening at the center of the polishing member thereby exposing the center portion of the cooling disc, and the fluid coupler is mounted on the center portion of the cooling disc exposed by the opening. The fluid coupler may include a rotatable coupler body which is fixedly mounted on the center portion of the cooling disc and has a connection path fluidly connected to the cooling fluid path in the cooling disc and a stationary central member rotatably connected to the coupler body at the center of the coupler body thereby enabling the coupler body to rotate together with the cooling disc relative to the stationary central member. The stationary central member includes a fluid path having a first end port adapted to be fluidly connected to the cooling fluid supply and a second end port fluidly connected to the connecting path in the coupler body.

### BRIEF DESCRIPTION OF THE DRAWINGS

Fig. 1 is a cross sectional side elevational view of a polisher in accordance with a preferred embodiment of the present invention,

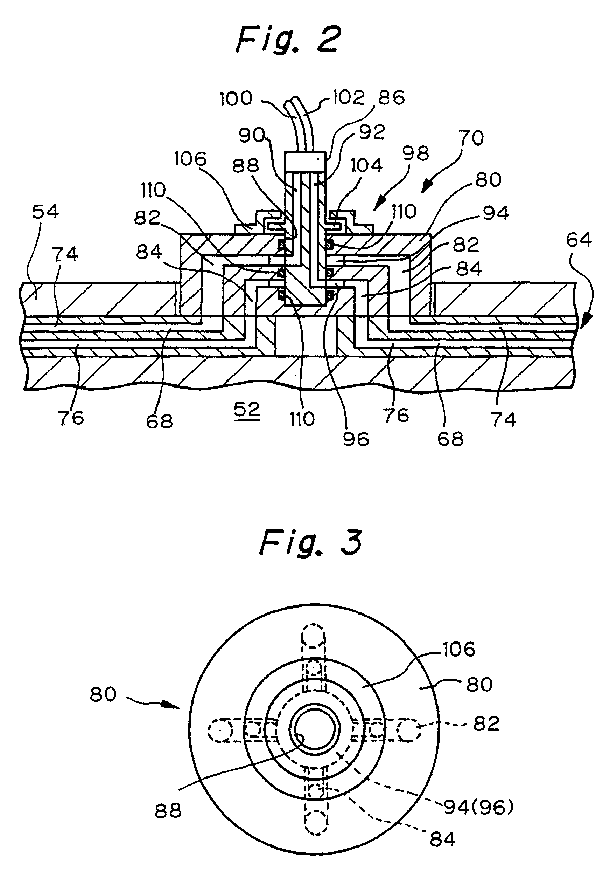

Fig. 2 is an enlarged sectional side elevational view of an important portion of a cooling system adopted in the polisher shown in Fig. 1, and
Fig. 3 is a plan view of a coupler body of the cooling system shown in Fig. 2.

### BEST MODE FOR CARRYING OUT THE INVENTION

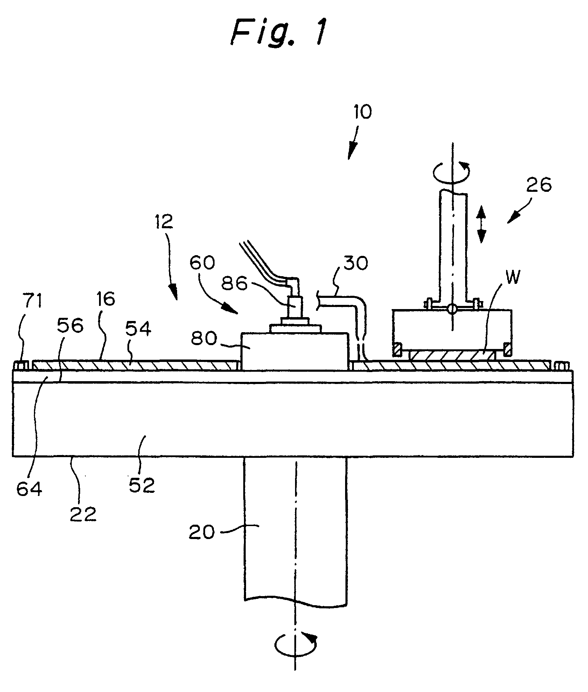

A polisher 10 shown in Fig. 1 includes a turn table 12 having an upper polishing surface 16, a vertical drive shaft 20 connected to a lower surface 22 of the turn table at the center thereof for rotatably driving the turn table, a wafer carrier 26 for holding a semiconductor wafer W in contact with the polishing surface 16 and a nozzle 30 for supplying a slurry onto the polishing surface 16. As shown, the turn table 12 of the polisher 10 includes a rotatable disc 52 defining the above-stated lower surface 22 of the turn table, and a polishing member 54 such as a synthetic resin polishing pad, a grindstone disc or the like provided over an upper surface 56 of the rotatable disc 52 the upper surface of which constitutes the above-stated polishing surface 16. In operation, the turn table 12 and the wafer carrier 26 are rotated about their respective axes, while supplying a slurry through the nozzle 30, whereby the wafer is polished mechanically and chemically by a combination of the polishing surface 16 and the supplied slurry.

The polisher 10 in accordance with the present invention further includes a cooling system 60 for cooling the polishing member 54 to deprive the polishing surface 16 of a heat generated by friction between the wafer W and the polishing surface 16 in a polishing operation as stated above.

Specifically, the cooling system 60 includes a cooling disc 64 provided between the polishing member 54 and the rotatable disc 52 which cooling disc includes a cooling fluid path 68 provided therein and a fluid coupler 70 provided on the cooling disc 64 at the center thereof for fluidly connecting the cooling fluid path 68 in the cooling disc with a cooling fluid supply (not shown) outside of the turn table. The cooling disc 64 is removably fastened to the rotatable disc 52 by bolts 71 located along the periphery of the cooling disc and the polishing member 54 is adhered to the upper surface of the cooling disc. The cooling disc 64 may be integrally incorporated into or integrally formed with the rotatable disc 52.

The cooling fluid path 68 is in the form of a round-trip path and includes a plurality sending paths 74 which extend in radial directions of the cooling disc 64 and are spaced from each other in a circumferential direction of the same and a plurality of return paths 76 which also extend radially and are connected to the sending paths 74 at around the periphery of the cooling disc. As shown, the sending paths 74 are positioned closer to the polishing member 54 than the return-paths taking a cooling efficiency into consideration.

The fluid coupler 70 includes a rotatable coupler body 80 fixedly mounted on the center portion of the cooling disc 64 and having a sending connection path 82 and a return connection path 84 which are respectively connected to the sending paths 74 and the return paths 76 of the cooling disc. The coupler 70 further includes a stationary cylindrical central member 86 inserted into a vertical hole 88 formed at the center of the rotatable coupler body 80 in such a manner that the rotatable coupler body 80 can rotate about its axis together with the rotatable disc 52 relative to the stationary central member 86. The stationary central member has a sending path 90 and a return path 92 respectively adapted to fluidly connect the sending connection path 82 and the returnconnection path 84 in the coupler body 80 to the cooling fluid supply (not shown) through pipes 100, 102 connected thereto so as to form a circular path for supplying a cooling fluid from the supply to the cooling disc 64 through the sending path 90, the sending connection path 82 and the sending paths 74 and for returning the cooling fluid from the cooling disc to the cooling fluid supply through the return paths 76, the return connection path 84 and the return path 92 in order to cool the returned cooling fluid. The outlets of the sending path 90 and the return path 92 in the stationary central member are connected to the sending connection paths 82 and the return connection paths 84 through circular grooves 94, 96 formed in the inner wall of the vertical hole 88 of the rotational coupler body which are, respectively, fluidly connected to the sending connection paths 82 and the return connection paths 84 and are positioned at the same levels as those of the lower ends of the sending path 90 and the return path 92 of the stationary central member 80 facing the inner wall of the vertical hole, whereby the sending path 90 and the return path 92 of the stationary central member are always fluidly connected to the sending connection paths 82 and the return connection paths 84, respectively.

In this embodiment, a thrust bearing 98 is provided between the stationary central member 86 and the rotatable coupler body 80 which consists of a collar 104 integrally formed on the stationary central member 86 and an annular bearing member 106 fixedly connected to the top surface of the rotatable coupler body 80 to surround the collar so that the rotatable coupler body 80 can stably rotate about its axis relative to the stationary central member 86. Reference numerals 110 designate O-rings for sealing the above-stated cooling fluid paths.

As stated above, in contrast to the conventional art, in the present invention, a cooling system is provided on a polisher turn table having a polishing surface free of a drive shaft of the turn, whereby it is possible to make the construction of the cooling system simple thereby simplifying maintenance, lowering costs and so. Accordingly, this invention also makes it possible to enhance cooling of a polishing member.

## Claims

1. A polisher (10) comprising:
a turn table (12) having first and second end surfaces (16, 22) which are substantially normal to an axis of said turn table, said first end surface (16) defining a polishing surface for polishing an article,
a drive shaft (20) connected to said turn table (12) and extending along the axis of said turn table (12) outwardly from said second end surface (22) of said turn table (12), the drive shaft (20) being adapted to rotatably drive the turn table (12), and
a cooling system (60) including a cooling fluid path (68) provided in said turn table (12) for passing a cooling fluid therethrough to deprive said polishing surface of a heat generated in a polishing operation,
**characterised by** a fluid coupler (70) provided at the center of said first end surface (16) of said turn table (12) for fluidly connecting said cooling fluid path (68) with a cooling fluid supply outside of said turn table 12.

2. A polisher (10) as set forth in Claim 1 in which said turn table (12) comprises a rotatable disc (52) and a disc-like polishing member (54) axially aligned with said rotatable disc (52), said rotatable disc (52) defining said second end surface (22) of said turn table, said polishing member (54) defining said polishing surface, said cooling system (60) including a cooling disc (64) provided between said polishing member (54) and said rotatable disc (52), said cooling disc (64) being provided with said cooling fluid path (68) therein.

3. A polisher (10) as set forth in Claim 2 in which said cooling disc (64) is removably provided on said rotatable disc (52).

4. A polisher (10) as set forth in Claim 2 in which said polishing member (54) is a polishing pad.

5. A polisher (10) as set forth in Claim 2 in which said cooling disc (64) is removably provided on said rotatable disc (52) and said polishing member (54) is a polishing pad adhered to said cooling disc (64).

6. A polisher as set forth in Claim 2 in which said polishing member (54) is a grindstone disc.

7. A polisher (10) as set forth in Claim 2 in which said polishing member (54) is provided with an opening at the center of said polishing member (54) thereby exposing said center portion of said cooling disc (64) and said fluid coupler (70) is mounted on said center portion of said cooling disc (64) exposed by said opening.

8. A polisher (10) as set forth in Claim 7 in which said fluid coupler (70) includes a rotatable coupler body (80) coaxially and fixedly mounted on said center portion of said cooling disc (64) and having a connection path (82, 84) fluidly connected to said cooling fluid path (68) in said cooling disc (64) and a stationary central member (86) rotatably connected to said coupler body (80) at the center of said coupler body (80) thereby enabling said coupler body (80) to rotate together with said cooling disc (64) relative to said stationary central member (86), said stationary central member (86) being provided with a fluid path (90, 92) having a first end port adapted to be fluidly connected to said cooling fluid supply and a second end port fluidly connected to said connecting path of said coupler body (80).

9. A polisher (10) as set forth in Claim 8 in which said rotatable coupler body (80) includes a through hole (88) at the center thereof and said stationary central member (86) is coaxially and rotatably received in said through hole (88) of said coupler body (80).

## Patentansprüche

1. Eine Poliervorrichtung (10) die folgendes aufweist:
einen Drehtisch (12) mit ersten und zweiten Endoberflächen (16, 22) die im wesentlichen senkrecht zu einer Achse des Drehtisches verlaufen, wobei die erste Endoberfläche (16) eine Polieroberfläche für das Polieren eines Gegenstandes definiert,
eine Antriebswelle (20) verbunden mit dem Drehtisch (12) und sich entlang der Achse des Drehtisches (22) nach Außen von der erwähnten zweiten Endoberfläche (22) des Drehtisches (12) erstreckend, wobei die Antriebswelle (20) geeignet ist den Drehtisch (12) drehbar anzutreiben, und
ein Kühlsystem (60) mit einem Kühlströmungsmittelpfad (68) vorgesehen in dem Drehtisch (12) zum Durchleiten eines Kühlströmungsmittels dahindurch, um von der erwähnten Polieroberfläche in einem Poliervorgang erzeugte Wärme abzuführen, **dadurch gekennzeichnet**, das ein Strömungsmittelkoppler (70) an der Mitte der ersten Endoberfläche (16) des Drehtisches (12) vorgesehen ist, um den Kühlströmungsmittelpfad (68) mit einer Kühlströmungsmittelversorgung außerhalb des Drehtisches strömungsmittelmäßig zu verbinden.

2. Poliervorrichtung (10) nach Anspruch 1, wobei der Drehtisch (12) eine drehbare Scheibe (52) und ein scheibenartiges Polierglied (54) aufweist, und zwar axial ausgerichtet mit der drehbaren Scheibe (52), und wobei die drehbare Scheibe (52) die erwähnte zweite Endoberfläche (22) des Drehtisches definiert, und wobei das Polierglied (54) die erwähnte Polieroberfläche definiert, und das Kühlsystem (60) eine Kühlscheibe (64) aufweist, und zwar vorgesehen zwischen dem erwähnten Polierglied (54) und der erwähnten Drehscheibe (52), wobei die Kühlscheibe (64) mit dem erwähnten Kühlströmungsmittelpfad (68) darinnen vorgesehen ist.

3. Poliervorrichtung (10) nach Anspruch 2, wobei die erwähnte Kühlscheibe (64) entfernbar auf der erwähnten Drehscheibe (52) vorgesehen ist.

4. Eine Poliervorrichtung (10) nach Anspruch 2, wobei das erwähnte Polierglied (54) ein Polierkissen bzw. Polierpad ist.

5. Eine Poliervorrichtung (10) nach Anspruch 2, wobei die Kühlscheibe (64) entfernbar auf dem Drehtisch (52) vorgesehen ist, und wobei das Polierglied (54) ein Polierkissen anhaftend an bzw. angeklebt an der Kühlscheibe (64) ist.

6. Eine Poliervorrichtung (10) nach Anspruch 2, wobei das Polierglied (54) eine Schleifsteinscheibe ist.

7. Eine Poliervorrichtung (10) nach Anspruch 2, wobei das Polierglied (54) an der Mitte des Polierglieds (54) mit einer Öffnung versehen ist, wodurch der Mittelteil der Kühlscheibe (64) freigelegt wird, und wobei der Strömungsmittelkoppler (70) an dem erwähnten Mittelteil der Kühlscheibe (64) freigelegt durch die erwähnte Öffnung angebracht ist.

8. Eine Poliervorrichtung (10) nach Anspruch 7, wobei der Strömungsmittelkoppler (70) einen drehbaren Kupplerkörper (80) aufweist, und zwar koaxial und fest an dem Mittelteil der Kühlscheibe (64) angebracht und mit einem Kühlpfad (82, 84) strömungsmittelmäßig verbunden mit dem Kühlströmungsmittelpfad (68) in der Kühlscheibe (64) und mit einem stationären mittigen Glied (86) drehbar verbunden mit dem Kupplerkörper (80) an der Mitte des erwähnten Kupplerkörpers (80) wodurch der Kupplerkörper (80) in die Lage versetzt wird, zusammen mit der Kühlscheibe (64) relativ zu dem erwähnten stationären Mittelglied (86) zu rotieren, wobei das stationäre Mittelglied (86) mit einem Strömungsmittelpfad (80, 82) versehen ist, und zwar mit einem ersten Endteil geeignet für eine strömungsmittelmäßige Verbindung mit der Kühlströmungsmittelversorgung und einem zweiten Endanschluß strömungsmittelmäßig verbunden mit dem erwähnten Verbindungspfad des Kupplerkörpers (80).

9. Eine Poliervorrichtung (10) nach Anspruch 8, wobei der drehbare Kupplerkörper (8) ein Durchgangsloch (88) an der Mitte desselben aufweist, und wobei das stationäre Mittelglied (86) koaxial und drehbar in dem Durchgangsloch (88) des Kupplerkörpers (80) aufgenommen ist.

## Revendications

1. Polisseuse (10) comprenant :
une plaque tournante (12) dont la première et la seconde surfaces d'extrémité (16, 22) sont en grande partie perpendiculaires à un axe de ladite plaque tournante, ladite première surface d'extrémité (16) définissant une surface de polissage pour polir un article,
un arbre d'entraînement (20) raccordé à ladite plaque tournante (12) et s'étendant le long de l'axe de ladite plaque tournante (12) vers l'extérieur de ladite seconde surface d'extrémité (22) de ladite plaque tournante (12), l'arbre d'entraînement (20) étant adapté à la commande de rotation de la plaque tournante (12), et
un système de refroidissement (60) comprenant un canal de liquide de refroidissement (68) équipant ladite plaque tournante (12) pour le passage d'un liquide de refroidissement pour priver ladite surface de polissage d'une chaleur générée par une opération de polissage, **caractérisé par** un coupleur hydraulique (70) fourni au centre de ladite première surface d'extrémité (16) de ladite plaque tournante (12) pour raccorder facilement ledit canal du liquide de refroidissement (68) à une alimentation en liquide de refroidissement extérieure à ladite plaque tournante (12).

2. Polisseuse (10) telle qu'énoncée dans la revendication 1 dans laquelle ladite plaque tournante (12) comprend un disque rotatif (52) et un élément de polissage de type disque (54) aligné axialement avec ledit disque rotatif (52), ledit disque rotatif (52) définissant ladite seconde surface d'extrémité (22) de ladite plaque tournante, ledit élément de polissage (54) définissant ladite surface de polissage, ledit système de refroidissement (60) incluant un disque de refroidissement (64) fourni entre ledit élément de polissage (54) et ledit disque rotatif (52), ledit disque de refroidissement (64) étant fourni avec le canal de liquide de refroidissement (68).

3. Polisseuse (10) telle qu'énoncée dans la revendication 2 dans laquelle le disque de refroidissement (64) est amovible et installé sur ledit disque rotatif (52).

4. Polisseuse (10) telle qu'énoncée dans la revendication 2 dans laquelle ledit élément de polissage (54) est un tampon à polir.

5. Polisseuse (10) telle qu'énoncée dans la revendication 2 dans laquelle ledit disque de refroidissement (64) est amovible et installé sur ledit disque rotatif (52) et ledit élément de polissage (54) est un tampon à polir collé au dit disque de refroidissement (64).

6. Polisseuse(10) telle qu'énoncée dans la revendication 2 dans laquelle ledit élément de polissage (54) est un disque équipé d'une meule.

7. Polisseuse (10) telle qu'énoncée dans la revendication 2 dans laquelle ledit élément de polissage (54) est fourni avec une ouverture au centre dudit élément de polissage (54) exposant ainsi ladite portion centrale dudit disque de refroidissement (64) et ledit coupleur hydraulique (70) est installé sur ladite portion centrale dudit disque de refroidissement (64) exposée par ladite ouverture.

8. Polisseuse (10) telle qu'énoncée dans la revendication 7 dans laquelle ledit coupleur hydraulique (70) inclut un corps de coupleur rotatif (80) installé d'une manière coaxiale et fixe sur ladite portion centrale dudit disque de refroidissement (64) et présentant un canal de raccordement (82, 84) facilement raccordé au dit canal de refroidissement (68) dans ledit disque de refroidissement (64) et un élément central stationnaire (86) rotatif raccordé au dit corps de coupleur (80) au niveau du centre dudit corps de coupleur (80) en permettant ainsi au dit corps de coupleur (80) de pivoter en même temps que ledit disque de refroidissement (64) par rapport au dit élément central stationnaire (86), ledit élément central stationnaire (86) étant fourni avec un canal de liquide (90, 92) présentant un premier port d'extrémité adapté à un raccordement facile à ladite alimentation en liquide de refroidissement et un second port d'extrémité facilement raccordé au dit canal de raccordement dudit corps de coupleur (80).

9. Polisseuse (10) telle qu'énoncée dans la revendication 8 dans laquelle ledit corps de coupleur rotatif (80) inclut un trou débouchant (88) en son centre et ledit élément central stationnaire (86) est reçu de manière coaxiale et rotative dans ledit trou débouchant (88) dudit corps de coupleur (80).
